# EUROPEAN PATENT APPLICATION

(11) **EP 2 487 722 A1**
(43) Date of publication of application: **15.08.2012**
(21) Application number: 11151435.2
(22) Date of filing: 19.01.2011
(51) Int. Cl.: H01L 31/032, H01L 31/18, H01L 31/0749

(54) **Light absorption layer**

(71) Applicant: Hitachi, Ltd., Chiyoda-ku Tokyo (JP)
(72) Inventor: Andreev, Aleksey, Cambridge, Cambridgeshire CB3 0HE (GB); Williams, David, Cambridge, Cambridgeshire CB3 0HE (GB); Miyamoto, Makoto, Tokyo Tokyo 100 8220 (JP); Yoshimoto, Naoki, Tokyo Tokyo 100 8220 (JP)
(74) Representative: Piotrowicz, Pawel Jan Andrzej

(57) **Abstract**

A method of fabricating a light absorption layer of a photovoltaic cell is disclosed. The method comprises depositing an alloy precursor on a base, the alloy precursor including a Group IB element, for example copper, a first Group IIIB element, for example indium, and a second Group IIIB element, for example gallium, annealing the alloy precursor so as to form an alloy and agitating the alloy precursor or alloy ultrasonically during and/or after annealing. The method may comprise zone annealing the alloy precursor.

## Description

The present invention relates to a light absorption layer of a photovoltaic cell particularly, but not exclusively, comprising copper indium gallium diselenide (CIGS).

Copper indium gallium diselenide (CIGS) is a promising material for mass-produced thin-film photovoltaic (or "solar") cells. CIGS photovoltaic cells are reasonably easy and cheap to make and those currently on the market have conversion efficiencies of about 9 to 11 %. Examples of CIGS photovoltaic cells are described in EP 1 424 735 A and JP 2009-170867 A.

The present invention seeks to increase conversion efficiency without significantly increasing manufacturing costs.

According to a fist aspect of the present invention there is provided a method of fabricating a light absorption layer of a photovoltaic cell, the method comprising depositing an alloy precursor on a base (such as a metalized substrate), the alloy precursor including a Group IB element, a first Group IIIB element and a second Group IIIB element, annealing the alloy precursor so as to form an alloy and agitating the alloy precursor or alloy ultrasonically during and/or after annealing.

Ultrasonic agitation can help to form a more uniform alloy having larger grain size. It can also assist migration and transformation of defects. Thus, a cheap and easy fabrication process can be used to increase the conversion efficiency of the photovoltaic cell.

The alloy precursor may further comprise a Group VIB element. Depositing the alloy precursor may comprise sputtering, for example co-sputtering, the elements on the base. Additionally or alternatively, annealing the alloy may comprise annealing the alloy precursor in an atmosphere comprising a Group VIB element.

The Group IB element may comprise copper. The first and second Group IIIB elements may comprise indium and gallium respectively. The Group VIB element may be selenium. Thus, the alloy may comprise copper indium gallium diselenide (CuInₓGa₁₋ₓSe₂).

Agitating the alloy precursor or alloy ultrasonically may comprise agitating the alloy or precursor at a frequency between about 20 kHz and about 100 kHz. Agitating the alloy precursor or alloy ultrasonically may comprise agitating the alloy or precursor at a power density of between about 1 and about 10 Wcm⁻².

The method may comprise agitating the alloy ultrasonically after ceasing to supply energy for annealing the precursor alloy so as to form the alloy before the alloy has substantially cooled to ambient temperature.

Annealing the alloy precursor may comprise zone annealing selective regions of the alloy precursor. This can help to form a more uniform alloy having larger grain size.

According to a second aspect of the present invention there is provided a method of fabricating a light absorption layer of a photovoltaic cell, the method comprising depositing an alloy precursor on a base (such as a metalized substrate), the alloy precursor including a Group IB element, a first Group IIIB element and a second Group IIIB element and zone annealing selective regions of the alloy precursor.

This can help to form a more uniform alloy having larger grain size.

The method may comprise moving heating element(s) relative to alloy precursor.

The method may further comprise depositing a buffer over the alloy, the buffer comprising a group IIB element, for example cadmium, and a group VIB element, such as sulphur.

According to a third aspect of the present invention there is provided a photovoltaic cell comprising a light absorption layer fabricated using the method.

According to a fourth aspect of the present invention there is provided apparatus for fabricating a light absorbing layer of a photovoltaic cell, the apparatus comprising deposition apparatus for depositing an alloy precursor on a base, the alloy precursor layer including a Group IB element, a first Group IIIB element and a second Group IIIB element, a reactor for annealing the alloy precursor so as to form an alloy and a transducer for agitating the alloy precursor or alloy ultrasonically during or after annealing.

The deposition apparatus may comprise a sputtering system.

The apparatus according may further comprise an ultrasonic transducer removably attachable to the base or a support for the base.

Certain embodiments of the present invention will now be described, by way of example, with reference to the accompanying drawings in which:
Figure 1 is a vertical sectional view of an embodiment of a photovoltaic cell in accordance with the present invention;
Figure 2 is a flow diagram of a method of fabricating the photovoltaic cell shown in Figure 1;
Figure 3 schematically illustrates a workpiece mounted to an ultrasonic transducer;
Figure 4 illustrates the effect of agitating the sample ultrasonically;
Figure 5 schematically illustrates a workpiece and a heat source;
Figure 6 illustrates a first annealing arrangement;
Figure 7 illustates a second annealing arrangement; and
Figure 8 illustrate a third annealing arrangement.

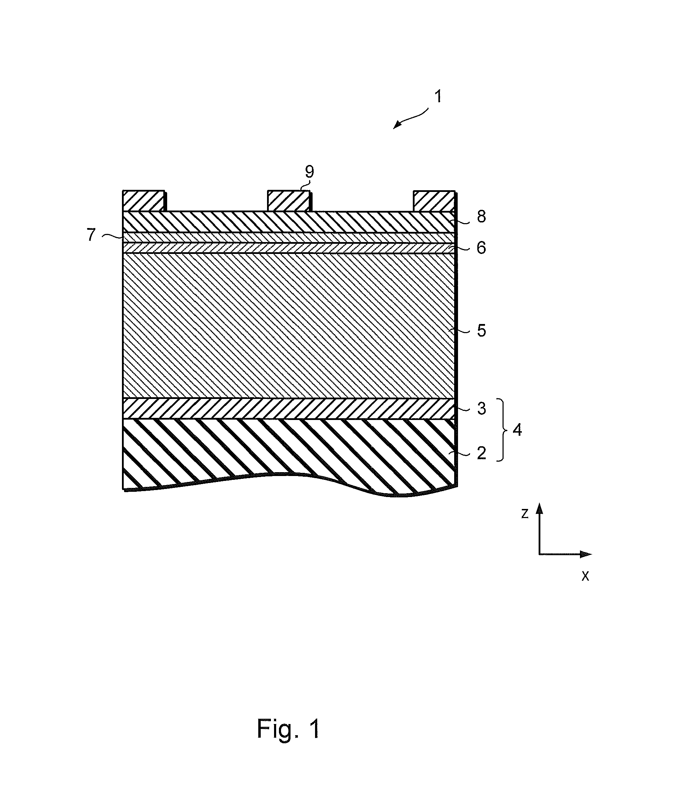

Referring to Figure 1, an embodiment of a thin-film photovoltaic cell 1 in accordance with the present invention is shown. The photovoltaic cell 1 is based on copper indium gallium diselenide (CuInₓGa₁₋ₓSe₂).

The photovoltaic cell 1 has a substrate 2, which may comprises glass or plastic, and a first electrode layer 3 comprising molybdenum (Mo) disposed on the substrate 2. The substrate 2 and first electrode layer 3 provide a base 4 on which other layers are deposited and processed.

The photovoltaic cell 1 also includes light absorption layer 5 (which may also be referred to as a "light absorber layer") comprising copper indium gallium diselenide (CuInₓGa₁₋ₓSe₂) disposed on the first electrode layer 3, a thin layer 6 of cadmium sulphide (CdS) 6 disposed on the copper indium gallium diselenide layer 5 and a thin layer 7 of zinc oxide (ZnO) disposed on the cadmium sulphide layer 6.

A contact layer 8 comprising zinc oxide doped with aluminium is disposed on the zinc oxide layer 7 and provides a transparent top contact. A metal grid electrode 9 overlies the top contact 8.

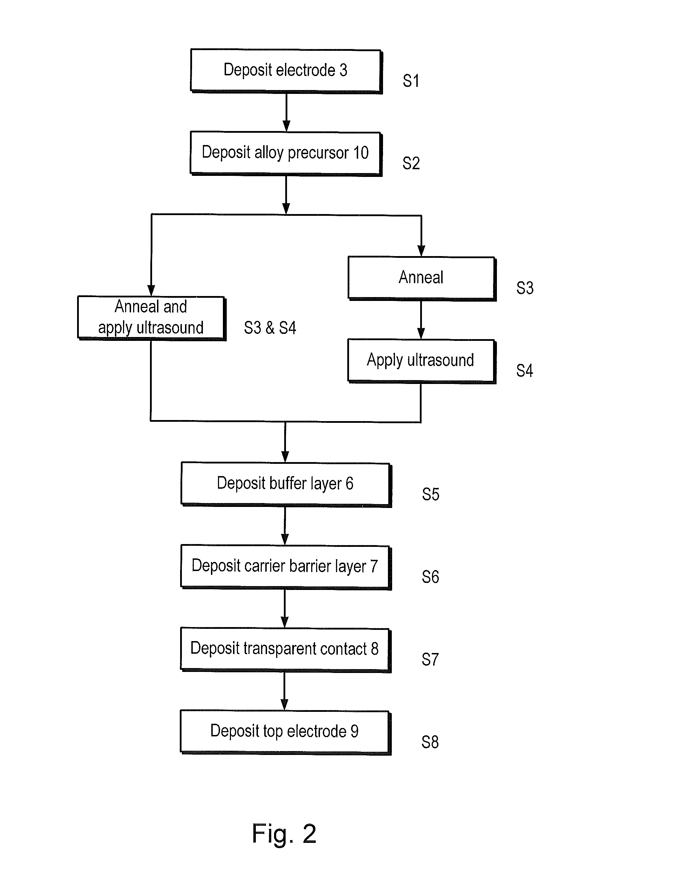

Referring also to Figure 2, a method of fabricating the photovoltaic cell will now be described.

A layer 3 of molybdenum is sputtered onto the substrate 2 (step S1). The molybdenum layer 3 can be patterned, for example, by laser ablation. An alloy precursor 10 is deposited by co-sputtering copper, gallium, indium and selenium onto the base 4 (step S2).

The alloy precursor is then annealed (step S3). During, or shortly after annealing, the alloy precursor 10 or alloy 5 is agitated ultrasonically (step S4). In some examples, ultrasound treatment can start during annealing and continue after annealing.

Subsequent layers 6, 7, 8, 9 are deposited in a conventional manner (steps S5 to S8).

Ultrasound treatment can help to influence grain formation, to assist formation of copper indium gallium diselenide having a homogeneous composition and to provide additional control over the formation of the alloy in particular by influencing annealing and diffusion and affecting migration and transformation of various defects and their complexes.

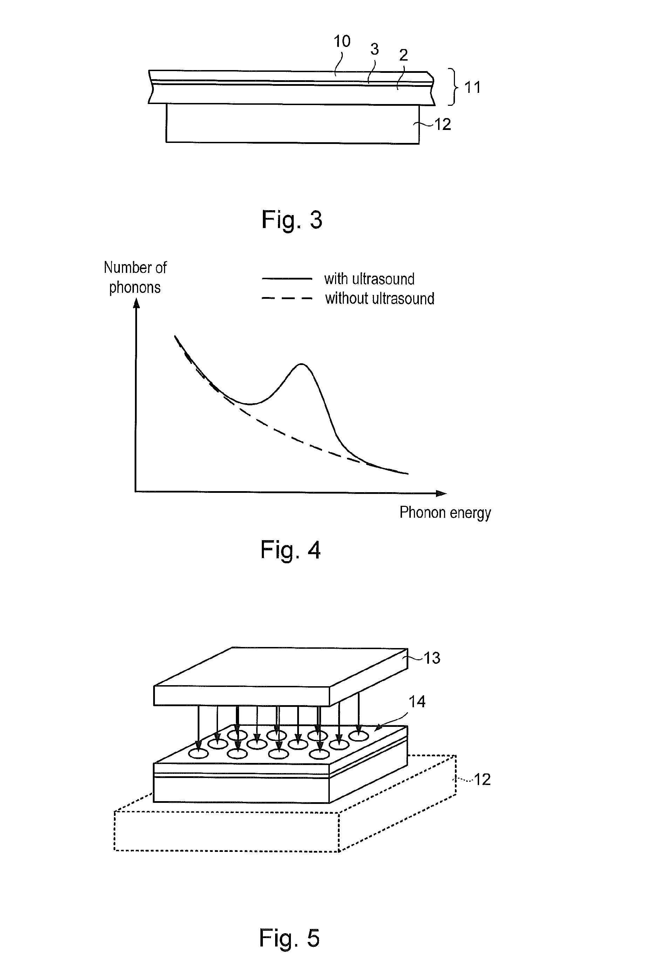

Referring also to Figure 3, an ultrasonic transducer 12 is pressed against or clamped to the underside of the alloy precursor-coated base 11 comprising the substrate 2, molybdenum electrode 3 and alloy precursor 10. The ultrasonic transducer 12 comprises a piezoelectric element (not shown) attached to a metal block (not shown). Suitable ultrasound treatment arrangements may be found in "Defect passivation using ultrasound treatment: fundamentals and application" by S. Ostapenko, Applied Physics A, volume 69, pages 225 ― 232 (1999).

Ultrasound is generated with the frequency corresponding to the resonance frequency of the ultrasonic transducer 12 which is determined by the size of the metal block (not shown). For example, the transducer 12 can exhibit resonant frequency of the order of several kHz corresponding to radial or lateral dimensions of the metal block (not shown) and another resonant frequency of the order of a few MHz corresponding to the thickness of the metal block (not shown). The transducer 12 is arranged to apply an ultrasound treatment at a frequency in the range of 20 to 100 kHz and a power density in the range 1 to 10 Wcm-².

Referring to Figure 4, the ultrasonic transducer 12 has the effect of pumping energy into the alloy precursor 10 and modifying the distribution of phonons within the alloy precursor 10. In particular, as shown in Figure 4, extra phonons of certain frequencies are generated in the alloy precursor 10. The presence of extra phonons changes the properties of the alloy precursor 10, for example, by changing the activation energy of defect migration and altering diffusion dynamics.

If the alloy precursor 10 is inhomogeneous, then agitation can help to create localised phonons, for example near defects, clusters or other regions, which locally have higher or lower than average composition of the alloy precursor. This leads to modification of the processes responsible for forming the thin-film alloy, such as (i) defect formation, transformation and transport, (ii) diffusion of different elements (including enhancement of diffusion processes), (iii) formation of alloy compounds, (iv) segregation of different phases of the materials, and (v) grain formation. Ultrasound reduces the diffusion activation energy by decreasing the energy barrier height for the diffusing atom. The induced modulation of the phonon distribution and stimulated population of excited states of the diffusing defects are responsible for a decrease of the activation energy and enhanced diffusion. Enhancement of In and Ga diffusion helps to provide a homogeneous composition of the alloy thin film. Use of ultrasound treatment may be especially effective for multi-junction solar cell structures.

Annealing can also be modified to control formation of the alloy. In particular, patterned zone-targeted annealing, i.e. a form of zone-melting re-crystallization, can be used to help form a uniform copper indium gallium diselenide thin film with large grains through additional control of temperature distribution and heat flow through the film.

During conventional copper indium gallium diselenide formation, spatial and/or temporal variations in the heat flow result in a non-uniform crystal formation front, which leads to a thin film having smaller grain and larger variations in composition.

Referring to Figure 5, a patterned array of heating elements 13 is used to provide greater control over annealing of the alloy precursor 10 so as to form a better alloy. The array 13 of heating elements or heat sources can provide different heat patterns 14. The heat patterns 14 may be spatially fixed (i.e. the alloy precursor-coated base 11 and heating element array 13 may be static during annealing) or move (i.e. the alloy precursor-coated base 11 and/or heating element array 13 may move during annealing). The heating elements 13 sources may take the forms of lamps, wires or lasers.

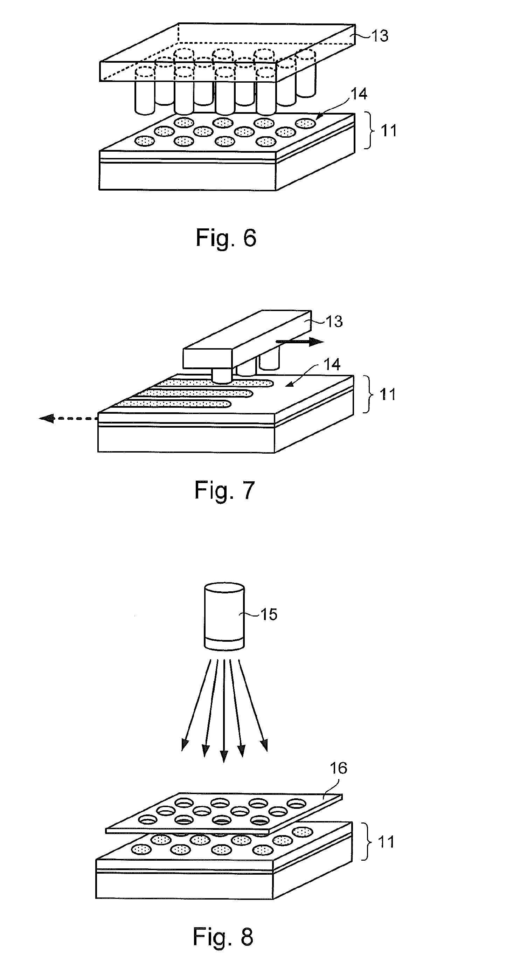

Referring to Figure 6, the heating element array 13 can take the form of a two-dimensional array 13 of heating elements. The positions of the alloy precursor-coated base 11 and the heating elements 13 may be fixed during annealing. However, the heating elements 13 can be turned on and off at different times, for example, to provide a moving heat front through the alloy precursor 10. As shown in Figure 6, of the alloy precursor-coated base 11 may be agitated during annealing by a transducer 12.

Referring to Figure 7, depending of the size of the sample and the structure of the photovoltaic cell, the array 13 can take the form of a one-dimensional (or strip) of heating elements which can be moved slowly in one direction with respect to the alloy precursor-coated base 11 or *vice versa.* A striped heat pattern 14 may be formed as the array is moved perpendicular to the line of heating elements. This arrangement can be useful for a roll-to-roll process of fabrication of the photovoltaic cell.

Zone-targeted patterned annealing can help to increase alloy grain size and provide a more homogeneous thin film. This is achieved by creating a lateral temperature gradient. By using the patterned annealing, the annealing (re-growth) front can be controlled. The shape and spatial and temporal dynamics of the re-growth front determine the formation of grains. The characteristics of the growth front are controlled by the shape of the heating element arrays and also by the speed of the array movement with respect to the sample.

Referring to Figure 8, zone-targeted annealing can be achieved using a powerful light source 15, for example a halogen lamp, for example, and a mask 16.

Using ultrasonic agitation and/or zone-targeted annealing can provide more uniform alloy thin-films having larger grains (in the case of a CIGS alloy, several microns) and provide greater control over the allow composition. This can help to maximise efficiency of the photovoltaic cell.

It will be appreciated that many modifications may be made to the embodiments hereinbefore described. For example, the alloy precursor may be deposited by evaporation. The alloy precursor can include additional elements. Selenium may be deposited separately or introduced during annealing. Ultrasound frequencies lower than 20 KHz or higher than 100 kHz can be used. Power densities lower than 1 Wcm⁻² or higher than 10 Wcm⁻² can be used.

## Claims

1. A method of fabricating a light absorption layer of a photovoltaic cell, the method comprising:
depositing an alloy precursor on a base, the alloy precursor including a Group IB element, a first Group IIIB element and a second Group IIIB element;
annealing the alloy precursor so as to form an alloy; and
agitating the alloy precursor or alloy ultrasonically during and/or after annealing.

2. A method according to claim 1, wherein the alloy precursor further comprises a Group VIB element, for example selenium.

3. A method according to claim 1 or 2, wherein depositing the alloy precursor comprises sputtering, for example co-sputtering, the elements on the base.

4. A method according to any preceding claim, wherein annealing the alloy comprises:
annealing the alloy precursor in an atmosphere comprising a Group VIB element, for example selenium.

5. A method according to any preceding claim, wherein the Group IB element comprises copper, the first Group IIIB element comprises indium and the second Group IIIB element comprises gallium.

6. A method according to any preceding claim, wherein agitating the alloy precursor or alloy ultrasonically comprises:
agitating the alloy or precursor at a frequency between about 20 kHz and about 100 kHz.

7. A method according to any preceding claim, wherein agitating the alloy precursor or alloy ultrasonically comprises:
agitating the alloy or precursor at a power density of between about 1 and about 10 Wcm⁻².

8. A method according to any preceding claim, comprising:
agitating the alloy ultrasonically after ceasing to supply energy for annealing the precursor alloy so as to form the alloy before the alloy has substantially cooled to ambient temperature.

9. A method according to any preceding claim, wherein annealing the alloy precursor comprises:
zone annealing selective regions of the alloy precursor.

10. A method according to claim 9, comprising:
moving heating element(s) relative to alloy precursor.

11. A method according to any preceding claim, further comprising:
depositing a buffer over the alloy, the buffer comprising a group IIB element, for example cadmium, and a group VIB element, such as sulphur.

12. A photovoltaic cell comprising the light absorption layer fabricated using a method according to any preceding claim.

13. Apparatus for fabricating a light absorbing layer of a photovoltaic cell, the apparatus comprising:
deposition apparatus for depositing an alloy precursor on a base, the alloy precursor layer including a Group IB element, a first Group IIIB element and a second Group IIIB element;
a reactor for annealing the alloy precursor so as to form an alloy; and
a transducer for agitating the alloy precursor or alloy ultrasonically during or after annealing.

14. Apparatus according to claim 13, wherein the deposition apparatus comprises a sputtering system.

15. Apparatus according to claim 13 or 14, further comprising:
an ultrasonic transducer removably attachable to the base or a support for the base.
